# EUROPÄISCHE PATENTSCHRIFT

(11) **EP 0 562 359 B1**
(45) Veröffentlichungstag und Bekanntmachung des Hinweises auf die Patenterteilung: **27.12.1995**
(21) Anmeldenummer: 93103831.9
(22) Anmeldetag: 10.03.1993
(51) Int. Cl.: H01S 3/096

(54) **Ansteuerschaltung für eine Laserdiode**
Laserdiode control circuit
Circuit pour commander une diode laser

(30) Priorität: 27.03.1992 DE 4210022
(43) Veröffentlichungstag der Anmeldung: 29.09.1993
(73) Patentinhaber: Alcatel SEL Aktiengesellschaft, D-70435 Stuttgart (DE); ALCATEL N.V., NL-1077 XX Amsterdam (NL)
(72) Erfinder: Kaiser, Norbert, W-7146 Tamm (DE); Manz, Werner, W-7022 Leinfelden-Echterdingen (DE)
(74) Vertreter: Pohl, Herbert, Dipl.-Ing.

(56) Entgegenhaltungen:
- EP-A- 0 385 470
- JOURNAL OF LIGHTWAVE TECHNOLOGY,Bd. LT-4, Nr. 3, März 1986, New York,US;Seiten 353 - 359,K.YAMASHITA et al.:"Master-slice monolithic integration design and characterictics of LD/LED transmitters for 100-400 MBIT/S optical transmission systems"

## Beschreibung

Die Erfindung betrifft eine Ansteuerschaltung für eine Laserdiode, die als elektro-optischer Wandler in optischen Nachrichtenübertragungssystemen eingesetzt wird. Dabei ist es üblich, einen Differenzverstärker zur Modulation des Lasers zu verwenden. Die Laserdiode wirkt unterhalb des sogenannten Schwellenstroms wie eine Leuchtdiode, und die optische Ausgangsleistung ist in diesem Strombereich sehr gering. Oberhalb des Schwellenstromes tritt dann die Laserwirkung ein, und die optische Ausgangsleistung Pₒₚₜ steigt linear mit wachsendem Modulationsstrom I_{mod} stark an. Der Anstieg der Funktion Pₒₚₜ = f(I_{mod}) ist abhängig vom verwendeten Lasertyp, vom Laserexemplar und ändert sich mit der Temperatur und der Alterung. Um die laut Datenblatt typischen optischen Ausgangsleistungen zu erhalten, ist beispielsweise für einen 0,8 »m-Laser hoher Quantenausbeute und niedriger Temperatur ein Modulationsstrom von I_{mod} = 5 mA erforderlich, bei 1,55 »m-Lasern und mäßiger Quantenausbeute muß I_{mod} = 40 mA betragen.

Bekannte Ansteuerschaltungen für eine Laserdiode sind mit einem Differenzverstärker ausgeführt, der an die Eigenschaften der jeweiligen Laserdiode angepaßt ist und auf maximalen Strom optimiert wurde, vgl. H.M. Rein: "Multi-Gigabit-Per-Second Silicon Bipolar IC's for Future Optical-Fiber Transmission Systems", IEEE Journal of Solid-State Circuits, Vol. 23, No. 3, June 1988, Seiten 664 bis 675 und K. Yamashita et al: "Master-Slice Monolithic Integration Design and Characteristics of LD/LED Transmitters for 100-400 Mbit/s Optical Transmission Systems", Journal of Lightwave Technology, VOL. LT-4, No. 3, March 1986, Seiten 353 bis 359. Die Optimierung auf maximalen Strom erfolgte bei den beschriebenen Lösungen deshalb, weil die Transitfrequenz eines Siliziumbipolartransistors von der Emitterstromdichte abhängig ist, vgl. H.-M. Rein, R. Ranft: "Integrierte Bipolarschaltungen", Springer-Verlag Berlin Heidelberg 1980, Seite 100 ff. Die Transitfrequenz nimmt mit geringer werdender Emitterstromdichte ab, und mit größer werdenden Transistorflächen nehmen die Sperrschichtkapazitäten und Kollektor-Substratkapazitäten des Transistors zu. Dadurch wird die optimale Bandbreite des Differenzverstärkers nur innerhalb eines kleinen Strombereichs erreicht, der wesentlich von der Emitterfläche abhängt und etwa dem Betrieb bei maximaler Emitterstromdichte entspricht. Wird bei diesen Ansteuerschaltungen die Emitterstromdichte beispielsweise um den Faktor 10 verringert, so nimmt der Einfluß der parasitären Kapazitäten auf das Impulsübertragungsverhalten derart zu, daß die Bandbreite stark eingeschränkt wird und die Impulsform sich wesentlich verschlechtert. Deshalb sind diese Ansteuerschaltungen nur für Laserdioden mit konstanten Eigenschaften geeignet, wenn nicht Nachteile im Impulsübertragungsverhalten auftreten sollen.

Es ist weiterhin eine Ansteuerschaltung für einen Halbleiterlaser bekannt, bei der eine Stromquelle über eine definierte Anzahl parallel geschalteter Transistoren mit dem Halbleiterlaser verbunden ist, vgl. EP-A-0385 470. Eine weitere definierte Anzahl parallel geschalteter Transistoren ist gegen Masse geschaltet. Die jeweilige Anzahl der parallel geschalteten Transistoren richtet sich nach dem Strombedarf des Halbleiterlasers. In einer Ausführungsform ist vorgesehen, daß die parallel geschalteten Transistoren jeweils zu Differenzverstärkern gehören, die mit einer gemeinsamen Stromquelle verbunden sind.

Der Erfindung liegt die Aufgabe zugrunde, eine Ansteuerschaltung anzugeben, deren Impulsübertragungsverhalten im wesentlichen unabhängig vom Modulationsstrombereich ist.

Diese Aufgabe wird durch eine Anordnung gelöst, wie sie im Anspruch 1 beschrieben ist. Durch eine Aufteilung des Modulationsstromes auf mehrere Differenzverstärker ist es möglich, den einzelnen Differenzverstärker so zu optimieren, daß er stets in der Nähe der maximalen Emitterstromdichte betrieben wird. Damit wird ein im Vergleich zum bekannten Stand der Technik besseres Impulsübertragungsverhalten in einem geforderten Strombereich erzielt, d.h., es sind größere Bitraten übertragbar oder es läßt sich andererseits bei einem spezifizierten Impulsverhalten der Bereich des einstellbaren Stromhubs wesentlich erweitern. So ist es möglich, mit der erfindungsgemäßen Ansteuerschaltung unterschiedliche Lasertypen, beispielsweise einen 0,8 »m-Laser oder einen 1,55 »m-Laser anzusteuern, ohne die Übertragungsgeschwindigkeit einschränken zu müssen. Ebenso ist eine Anpassung an veränderte Eigenschaften der Laserdiode bei Temperaturänderungen und bei Alterung der Laserdiode möglich. Die Anzahl der erforderlichen Differenzverstärker wird von dem jeweiligen Anwendungsfall bestimmt. In Abhängigkeit vom zu verarbeitenden Stromhub werden über eine Steuerschaltung die einzelnen Differenzverstärker aktiviert. Dabei kann die Steuerspannung digital sein, es ist aber auch möglich, mit einer analogen Steuerspannung zu arbeiten und den Stromhub kontinuierlich zu verändern. Die Ansteuerschaltung ist problemlos mit unterschiedlichen Ausführungsformen der Differenzverstärker realisierbar. So können beispielsweise die Transistorstufen der Differenzverstärker aus parallel geschalteten Einzeltransistoren bestehen, möglich ist auch eine Gegenkopplungsschaltung im Emitterzweig. Mit der erfindungsgemäßen Lösung wird eine universell einsetzbare Ansteuerschaltung angegeben, die vollständig als monolithisch integrierte Schaltung realisierbar ist.

Die Erfindung wird nachstehend an einem Ausführungsbeispiel erläutert. In der dazugehörigen Zeichnung zeigen
- Fig. 1: eine Schaltungsanordnung der Ansteuerschaltung und
- Fig. 2: ein Diagramm zur Darstellung der Funktion I_{mod} = f (Uₛₜ).

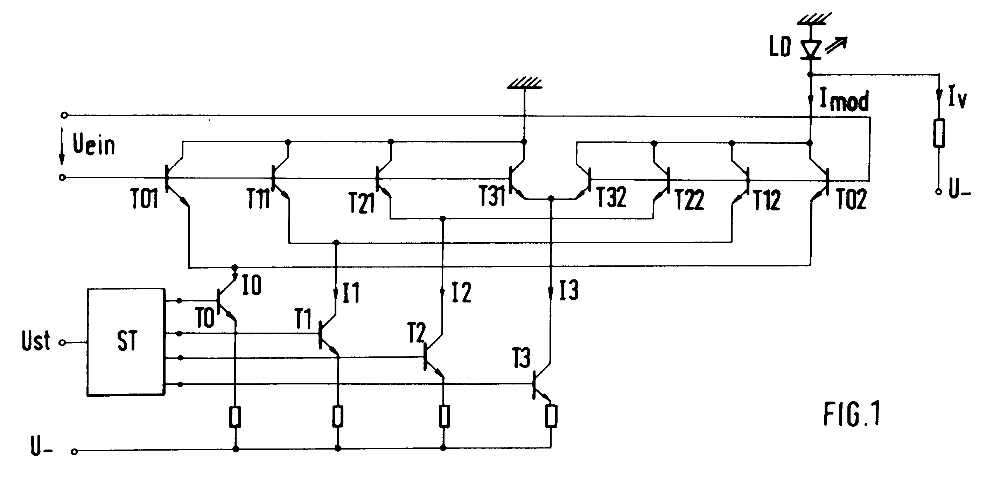

Gemäß Fig. 1 besteht die Schaltungsanordnung aus einem ersten Differenzverstärker T01, T02 mit einer Laserdiode LD in einer Ausgangsleitung und weiteren zu diesem ausgangsseitig und eingangsseitig parallel geschalteten Differenzverstärkern T11, T12; T21, T22; T31, T32. In der Emitterleitung jedes Differenzverstärkers liegt eine Reihenschaltung aus einem Stromquellentransistor T0, T1, T2, T3 und einem Widerstand, die eine Stromquelle bildet. Die Steuereingänge der den Differenzverstärkern zugeordneten Stromquellen mit den Strömen I0, I1, I2, I3 sind jeweils mit einem Ausgang einer Steuerschaltung ST verbunden. Weiterhin ist ein Stromkreis angedeutet, der die Laserdiode LD mit einem Vorstrom Iᵥ versorgt.

Bei kleinem Modulationsstrom I_{mod}, beispielsweise 1_{mod} ≦ 5 mA, wird von der Steuerschaltung ST nur die erste Stromquelle I0 des ersten Differenzverstärkers T01, T02 eingeschaltet. Somit wird bei diesem minimalen Modulationsstrom I_{mod} nur ein Differenzverstärker T01, T02 betrieben, dessen Transistoren optimal an diesen Strom angepaßt werden können. Für 5 mA ≦ I_{mod} ≦ 17 mA wird die zweite im Bereich 0 ≦ I1 ≦ 12 mA regelbare Stromquelle I1 des zweiten Differenzverstärkers T11, T12 dazugeschaltet, wobei der gewünschte Strom I1 durch die Größe der Steuerspannung Uₛₜ über die Steuerschaltung ST bestimmt wird. Bei kleinen vom zweiten Differenzverstärker T11, T12 gelieferten Strömen 11, beispielsweise im Bereich 0 ≦ I1 ≦ 5 mA, wird das Impulsverhalten der Ansteuerschaltung im wesentlichen von dem ersten Differenzverstärker T01, T02 mit der ersten Stromquelle I0 bestimmt. Im oberen Strombereich der zweiten Stromquelle 11, also im Bereich 5 mA ≦ I1 ≦ 12 mA, des zweiten Differenzverstärkers T11, T12 wird dieser in der Nähe des optimalen Arbeitsbereiches der Transistoren betrieben, da diese auf den Strom I1ₘₐₓ = 12 mA ausgelegt sind.

Mit der Vergrößerung des Modulationsstrombedarfs werden der dritte Differenzverstärker T21, T22 und der vierte Differenzverstärker T31, T32 mit der diesen jeweils zugeordneten dritten Stromquelle I2 beziehungsweise vierten Stromquelle I3 dazugeschaltet, so daß bei maximalem Modulationsstrom I_{mod} alle Stromquellen I0, I1, I2, I3 eingeschaltet sind.

Die Stromaufteilung erfolgt dann auf vier Differenzverstärker. Schon bei der Aufteilung des Modulationsstromes auf zwei Differenzverstärker ist ein besseres Impulsverhalten im Vergleich zu den aus dem Stand der Technik bekannten Schaltungen nachweisbar.

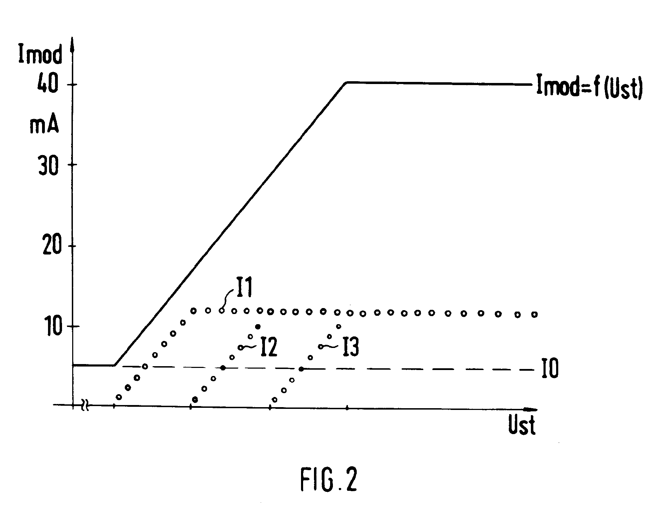

Fig. 2 zeigt die Abhängigkeit des Modulationsstromes I_{mod} von der Steuerspannung Uₛₜ mit den Anteilen der einzelnen in Abhängigkeit von der Steuerspannung Uₛₜ hinzugeschalteten Stromquellen. Als Beispiel ist in Fig. 2 dargestellt I0 = 5 mA und die drei weiteren Stromquellen I1 = I2 = I3 = 12 mA, so daß der maximale Modulationsstrom I_{mod} = 41 mA beträgt.

Die Dimensionierung der Differenzverstärker für einen optimalen Strom ist auf unterschiedliche Weise möglich. So kann die Aufteilung des Modulationsstromes I_{mod} auf die einzelnen Differenzverstärker auch ungleichmäßig erfolgen. Die erste Stromquelle I0 muß nicht auf den minimalen Modulationsstrom eingestellt werden, sie kann auch einen größeren Strombereich abdecken und regelbar sein. Ebenso ist eine Steuerschaltung für I0 bis In denkbar, die mit kleinen Steuerspannungsänderungen jede Stromquelle mit ihrem Stromanteil verändert, wobei sich die Steuerbereiche der einzelnen Stromquellen teilweise oder ganz überschneiden können.

## Patentansprüche

1. Ansteuerschaltung für eine Laserdiode (LD), die einen von einer Stromquelle (I0) versorgten ersten Differenzverstärker (T01, T02) enthält, dem mindestens ein weiterer Differenzverstärker so zugeschaltet ist, daß die jeweils ersten und zweiten Eingänge und die jeweils ersten und zweiten Ausgänge miteinander verbunden sind, und bei der die jeweiligen ersten Ausgänge der Differenzverstärker über die Laserdiode (LD) und die jeweiligen zweiten Ausgänge der Differenzverstärker direkt mit dem ersten Anschluß einer Spannungsquelle verbunden sind, so daß die Laserdiode (LD) gemeinsamer Arbeitswiderstand der Differenzverstärker ist, und bei der zwischen den ersten und den zweiten Eingängen der Differenzverstärker die Eingangsspannung (Uₑᵢₙ) liegt, **dadurch gekennzeichnet**, daß jeder Differenzverstärker separat über eine steuerbare Stromquelle (I0,I1,I2,I3) and den zweiten Anschluß (U-) der Spannungsquelle geschaltet ist, wobei die jeweiligen Steuereingänge der Stromquellen mit den Ausgängen einer Steuerschaltung (ST) verbunden sind, deren Eingang an einer Steuerspannung (Uₛₜ) liegt.

2. Ansteuerschaltung für eine Laserdiode (LD) nach Anspruch 1, dadurch gekennzeichnet, daß die Differenzverstärker Transistoren enthalten, deren Emitterflächen so gestaltet sind, daß sie im Bereich maximaler Emitterstromdichte betrieben werden.

3. Ansteuerschaltung für eine Laserdiode (LD) nach Anspruch 1, dadurch gekennzeichnet, daß die Ansteuerung der Stromquellen digital erfolgt.

## Claims

1. A driver circuit for a laser diode (LD), said driver circuit comprising a first differential amplifier (T01, T02) fed from a current source (I0) and having at least one further differential amplifier connected thereto in such a way that the respective first and second inputs and the respective first and second outputs are interconnected, with the respective first outputs of the differential amplifiers connected to the first terminal of a voltage source through the laser diode (LD), and the respective second outputs of the differential amplifiers connected directly to the first terminal of the voltage source, so that the laser diode (LD) is a common load resistor of the differential amplifiers, and with the input voltage (Uₑᵢₙ) applied between the first and second inputs of the differential amplifiers, **characterized** i n that each differential amplifier is connected separately to the second terminal (U_) of the voltage source via a controlled current source (I0, I1, I2, I3), with the respective control inputs of the current sources connected to the outputs of a control circuit (ST) having its input connected to a control voltage (Uₛₜ).

2. A driver circuit for a laser diode (LD) as claimed in claim 1, characterized in that the differential amplifiers contain transistors whose emitter areas are fashioned in such a way that the transistors are operated in the region of maximum emitter-current density.

3. A driver circuit for a laser diode (LD) as claimed in claim 1, characterized in that the current sources are controlled digitally.

## Revendications

1. Circuit de commande pour une diode laser (LD) qui contient un premier amplificateur différentiel (T01, T02) qui est alimenté par une source de courant (I0) et au circuit duquel s'ajoute au moins un autre amplificateur différentiel de façon telle que chacune des première entrées soient reliées entre elles, ainsi que chacune des secondes entrées et que chacune des première sorties soient reliées entre elles, ainsi que chacune des secondes sorties, et dans le cas duquel les premières sorties de chacun des amplificateurs différentiels sont reliées, par l'intermédiaire de la diode laser (LD), à la première borne d'une source de courant et les secondes sorties de chacun des amplificateurs différentiels le sont directement, de sorte que la diode laser (LD) est une résistance de travail commune des amplificateurs différentiels, et dans le cas duquel entre les premières et les secondes sorties des amplificateurs différentiels se trouve la tension d'entrée (Uₑᵢₙ), caractérisé par le fait que chaque amplificateur différentiel est relié séparément à la seconde borne (U -) de la source de tension par l'intermédiaire d'une source de courant (I0, I1, I2, I3), qui peut se commander. chacune des entrées de commande des sources de courant étant reliée à l'une des sorties d'un circuit de commande (ST) dont l'entrée est mise à la tension de commande (Uₛₜ).

2. Circuit de commande pour une diode laser (LD) selon la revendication 1, caractérisé par le fait que les amplificateurs différentiels contiennent des transistors dont les surfaces des émetteurs sont réalisées de façon qu'ils fonctionnent sur la plage de la densité de courant maximale de l'émetteur.

3. Circuit de commande pour une diode laser (LD) selon la revendication 1, caractérisé par le fait que la commande des sources de courant se fait numériquement.
